# EUROPEAN PATENT APPLICATION

(11) **EP 1 883 114 A1**
(43) Date of publication of application: **30.01.2008**
(21) Application number: 06015610.6
(22) Date of filing: 26.07.2006
(51) Int. Cl.: H01L 29/267, H01L 29/861, H01L 29/78

(54) **Heterojunction semiconductor device and method of producing the semiconductor device**

(71) Applicant: NISSAN MOTOR CO., LTD., Yokohama-shi, Kanagawa 221-0023 (JP)
(72) Inventor: Tanaka, Hideaki, Yokohama-shi Kanagawa 236-0012 (JP); Hoshi, Masakatsu, Yokohama-shi Kanagawa 232-0073 (JP); Shimoida, Yoshio, Yokosuka-shi Kanagawa 239-0801 (JP); Hayashi, Tetsuya, Yokosuka-shi Kanagawa 237-0075 (JP); Yamagami, Shigeharu, Yokohama-shi Kanagawa 222-0032 (JP)
(74) Representative: Grünecker, Kinkeldey, Stockmair & Schwanhäusser Anwaltssozietät

(57) **Abstract**

A semiconductor device (20), includes: 1) an electric field relaxing area (5), including: i) a hetero junction (HJ) formed by the followings: a) a first semiconductor material (100: 1, 2), and b) a second semiconductor material {3A (7)} different from the first semiconductor material (100: 1, 2) in band gap, and ii) an impurity introducing area (4) so formed on the first semiconductor material (100: 1, 2) as to contact the hetero junction (HJ).

## Description

### BACKGROUND OF THE INVENTION

### 1. FIELD OF THE INVENTION

The present invention relates to a semiconductor device having high reverse blocking voltage, and a method of producing the semiconductor device.

### 2. DESCRIPTION OF THE RELATED ART

A non-patent document, specifically, "Power device - Power IC Handbook" written by High performance high function power device - power IC Research committee of The Institute of Electrical Engineers of Japan issued by Corona Publishing Co., Ltd. discloses, on pages 12 to 21 thereof, a Schottky junction, which is a junction for obtaining a diode having high reverse blocking voltage using a conventional silicon carbide. Based on silicon, the above non-patent document describes in detail about the junction for obtaining the diode having high reverse blocking voltage. The junction using the conventional silicon carbide is also widely used.

For realizing the diode having high reverse blocking voltage by applying the Schottky junction to the silicon carbide, a diffusion layer as an electric field relaxing area is to be formed at a Schottky electrode end, so as to relax an electric field concentration at the Schottky electrode end. For forming the diffusion layer, an ion implantation is used. In the case of the silicon carbide, however, high temperature more than or equal to 1,500° C is needed for an activating heat treatment after the ion implantation. In the activating heat treatment, a silicon carbide substrate surface is deteriorated, failing to form a good Schottky junction on the silicon carbide substrate surface which is deteriorated. As a result, the above non-patent document finds difficulty in realizing the diode having high reverse blocking voltage.

### SUMMARY OF THE INVENTION

It is therefore an object of the present invention to provide a semiconductor device featuring a high reverse blocking voltage and a method of producing the above semiconductor device.

According to a first aspect of the present invention, there is provided a semiconductor device, comprising: 1) an electric field relaxing area, including: i) a hetero junction formed by the followings: a) a first semiconductor material, and b) a second semiconductor material different from the first semiconductor material in band gap, and ii) an impurity introducing area so formed on the first semiconductor material as to contact the hetero junction.

According to a second aspect of the present invention, there is provided a semiconductor device, comprising: 1) a semiconductor substrate made of a first semiconductor material which is a first conductive type; 2) an anode} so formed as to contact a first main face of the semiconductor substrate; 3) a cathode so formed as to contact a second main face of the semiconductor substrate, the second main face opposing the first main face; and 4) an electric field relaxing area, including: i) a hetero junction disposed between the anode} and the semiconductor substrate, the hetero junction formed by the followings: a) the first semiconductor material, and b) a second semiconductor material different from the first semiconductor material in band gap, and ii) an impurity introducing area so formed on the first semiconductor material as to contact the hetero junction.

According to a third aspect of the present invention, there is provided a semiconductor device, comprising: 1) a switching element including an active area which includes at least the followings each of which is formed in a certain position of a semiconductor substrate made of a first semiconductor material, i) a source area, ii) a drain area, and iii) a drive area; and 2) an electric field relaxing area, including: i) a hetero junction formed by the followings: a) the first semiconductor material, and b) a second semiconductor material different from the first semiconductor material in band gap, and ii) an impurity introducing area so formed on the first semiconductor material as to contact the hetero junction.

According to a fourth aspect of the present invention, there is provided a method of producing the semiconductor device as set forth in the first aspect, the method comprising: 1) forming the hetero junction by the followings: i) the first semiconductor material, and ii) the second semiconductor material different from the first semiconductor material in band gap; 2) introducing an impurity to the second semiconductor material; and 3) forming the impurity introducing area.

The other object(s) and feature(s) of the present invention will become understood from the following description with reference to the accompanying drawings.

### BRIEF DESCRIPTION OF THE DRAWINGS

Fig. 1 is a cross sectional view showing a structure of a silicon carbide semiconductor device according to a first embodiment of the present invention.

Fig. 2 shows a method of producing the silicon carbide semiconductor device, according to the first embodiment.

Fig. 3A and Fig. 3B each show an energy band structure of the silicon carbide semiconductor device, according to the first embodiment.

Fig. 4 shows a reverse characteristic of the silicon carbide semiconductor device, which characteristic is obtained by an experimental result, according to the first embodiment.

Fig. 5 is a cross sectional view showing a structure of the silicon carbide semiconductor device, according to a second embodiment of the present invention.

Fig. 6A and Fig. 6B show a method of producing the silicon carbide semiconductor device, according to the second embodiment.

Fig. 7A, Fig. 7B, Fig. 7C and Fig. 7D show examples of applying the silicon carbide semiconductor device, according to the second embodiment.

Fig. 8 is a cross sectional view showing the silicon carbide semiconductor device with an anode made of metal, according to the second embodiment of the present invention.

Fig. 9 is a cross sectional view showing the silicon carbide semiconductor device with the anode made of another-shaped metal, according to the second embodiment of the present invention.

Fig. 10 is a cross sectional view showing a structure of the silicon carbide semiconductor device, according to a third embodiment of the present invention.

Fig. 11A, Fig. B, Fig. C and Fig. D show first partial views showing a method of producing the silicon carbide semiconductor device, according to the third embodiment.

Fig. 12A, Fig. 12B and Fig. 12C show second partial views showing the method of producing the silicon carbide semiconductor device, according to the third embodiment.

Fig. 13 is a cross sectional view showing a structure of the silicon carbide semiconductor device, according to a fourth embodiment of the present invention.

Fig. 14A, Fig. 14B, Fig. 14C and Fig. 14D are first partial views showing a method of producing the silicon carbide semiconductor device, according to the fourth embodiment.

Fig. 15A, Fig. 15B and Fig. 15C are second partial views showing the method of producing the silicon carbide semiconductor device, according to the fourth embodiment.

### DESCRIPTION OF THE PREFERRED EMBODIMENTS

In the following, various embodiments of the present invention will be described in detail with reference to the accompanying drawings.

For ease of understanding, the following description will contain various directional terms, such as left, right, upper, lower, forward, rearward and the like. However, such terms are to be understood with respect to only a drawing or drawings on which the corresponding part of element is illustrated.

### <First embodiment - structure>

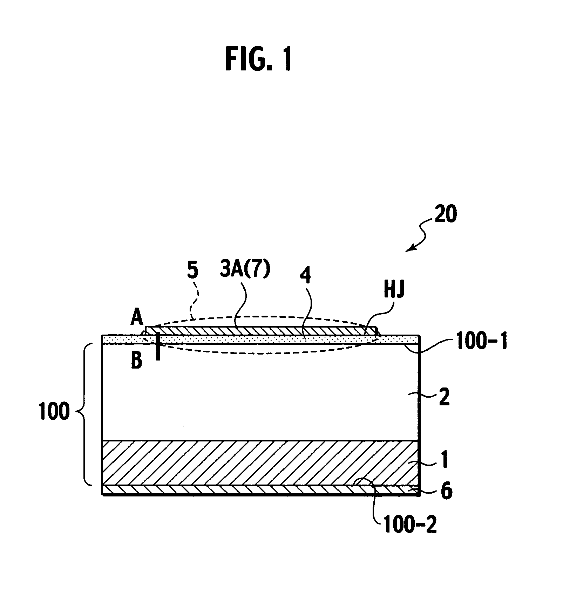

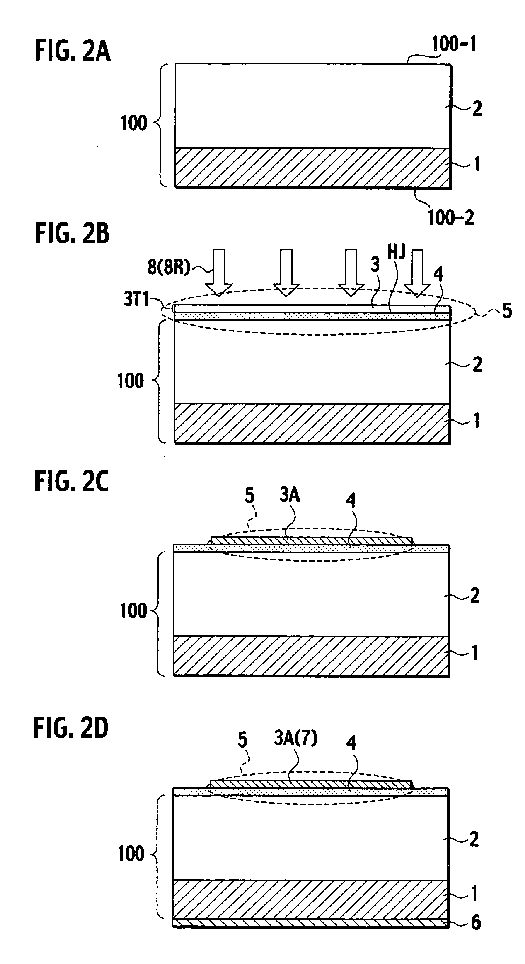

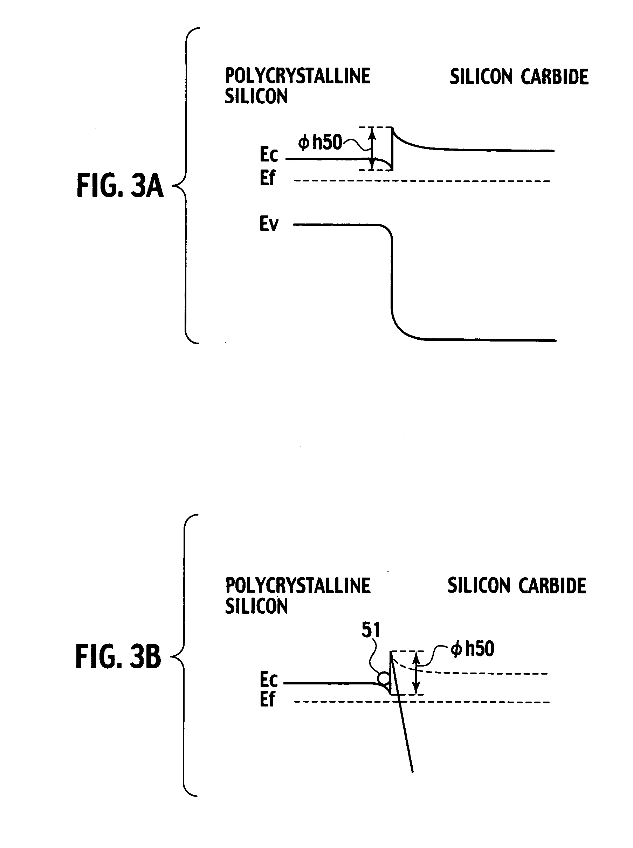

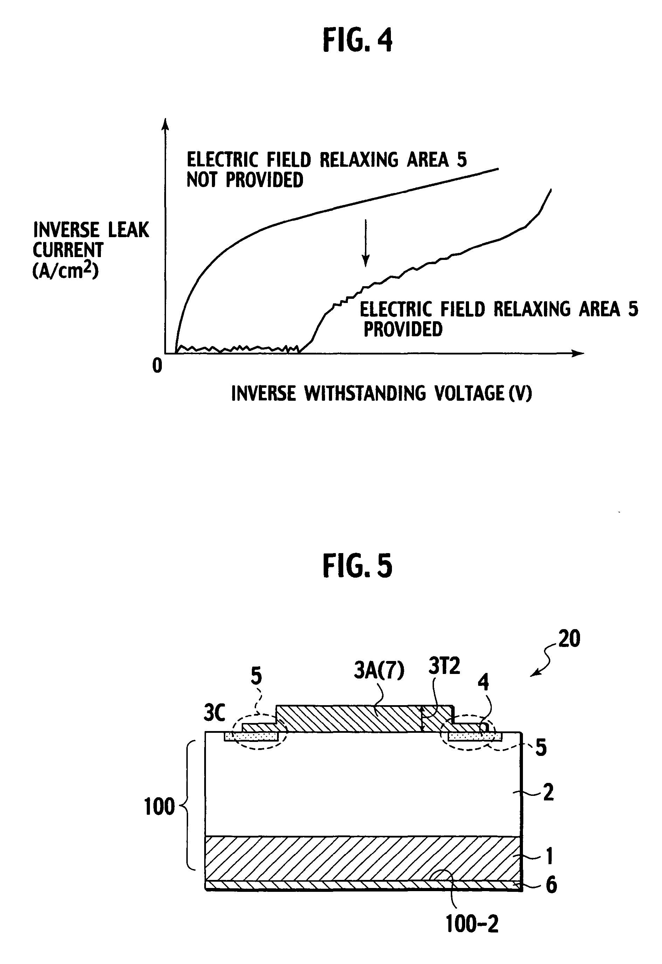

Fig. 1, Fig. 2 (Fig. 2A to Fig. 2D), Fig. 3 (Fig. 3A and Fig. 3B) and Fig. 4 show a silicon carbide semiconductor device 20 and drawings related thereto, according to a first embodiment of the present invention. Fig. 1 is a cross sectional view showing a structure of the silicon carbide semiconductor device 20, according to the first embodiment of the present invention.
Hereinafter, a superscript "+" in N⁺ denotes a relatively high impurity density while a superscript "-" in N⁻ denotes a relatively low impurity density.

In Fig. 1, forming an N⁻ silicon carbide epitaxial layer 2 on an N⁺ silicon carbide substrate 1 forms an N silicon carbide semiconductor substrate 100 which is a first conductive type. Specifically, the N silicon carbide semiconductor substrate 100 made of a first semiconductor material which is silicon carbide includes the N⁺ silicon carbide substrate 1 and the N⁻ silicon carbide epitaxial layer 2.

On a first main face 100-1 side of the N silicon carbide semiconductor substrate 100, in other words, on the N⁻ silicon carbide epitaxial layer 2 side, there is formed an N⁻ polycrystalline silicon layer 3A made of a second semiconductor material which is an N⁻ polycrystalline silicon. The N⁻ polycrystalline silicon (second semiconductor material) is different from the silicon carbide (first semiconductor material) in band gap. Between the N⁻ silicon carbide epitaxial layer 2 and the N⁻ polycrystalline silicon layer 3A, there is formed a hetero junction HJ.

In addition, on the first main face 100-1 side of the N silicon carbide semiconductor substrate 100, in other words, on the N⁻ silicon carbide epitaxial layer 2 side, there is formed an electric field relaxing area 5 including an impurity introducing area 4 (to which an impurity is introduced) so formed as to contact the hetero junction HJ. On a back face (lower in Fig. 1) of the N⁺ silicon carbide substrate 1, there is formed a cathode 6 made of a conductor material such as metal and the like. In addition, the N⁻ polycrystalline silicon layer 3A so formed as to contact the N⁻ silicon carbide epitaxial layer 2 serves also as an anode 7.

In other words, the silicon carbide semiconductor device 20 shown in Fig. 1 has a structure of a diode including the anode 7 {the N⁻ polycrystalline silicon layer 3A} and the cathode 6.

### <First embodiment - production method>

Hereinafter described referring to Fig. 2A to Fig. 2D is a method of producing the silicon carbide semiconductor device 20 in Fig. 1, according to the first embodiment of the present invention.

At first, as shown in Fig. 2A, the N⁻ silicon carbide semiconductor substrate 100 is prepared which has the N⁻ silicon carbide epitaxial layer 2 formed on the N⁺ silicon carbide substrate 1. The N⁻ silicon carbide epitaxial layer 2 has density and thickness, for example, 1 × 10¹⁶ cm⁻³ and 10 µm, respectively.

Then, as shown in Fig. 2B, the N⁻ polycrystalline silicon is deposited on the N⁻ silicon carbide epitaxial layer 2 side of the N silicon carbide semiconductor substrate 100 by an LP-CVD method (LP-CVD denotes Low Pressure Chemical Vapor Deposition), to thereby form the polycrystalline silicon layer 3. In this case, the polycrystalline silicon layer 3 has a first thickness 3T1, for example, 1,000 angstrom. Then, a phosphor 8 is implanted in the polycrystalline silicon layer 3 by the ion implantation method, to thereby introduce the impurity in the N⁻ polycrystalline silicon.

Herein, conditions of the above ion implantation include, for example, acceleration voltage of 70 KeV and dose quantity of 1 × 10¹⁴ cm⁻². Under the above conditions, the thus implanted phosphor 8 has a range 8R larger than the first thickness 3T1 of the polycrystalline silicon layer 3. Therefore, the phosphor 8 (impurity) is implanted also in the N⁻ silicon carbide epitaxial layer 2 side via the polycrystalline silicon layer 3, to thereby form the impurity introducing area 4, thus forming the electric field relaxing area 5 including i) the hetero junction HJ between the N⁻ silicon carbide epitaxial layer 2 and the polycrystalline silicon layer 3 and ii) the impurity introducing area 4.

Then, as shown in Fig. 2C, the thus obtained is subjected to a heat treatment in a nitrogen atmosphere at 950° C for 20 minutes, to thereby activate (annealing) the phosphor 8 implanted in the polycrystalline silicon layer 3. Then, the polycrystalline silicon layer 3 is patterned by a photolithography and an etching, to thereby form the N⁻ polycrystalline silicon layer 3A.

Then, as shown in Fig. 2D, Ti (titanium) and Ni (nickel) are sequentially deposited on the back face (lower in Fig. 2D) of the N⁺ silicon carbide substrate 1 by a spattering method. Then, the thus obtained is subjected to an RTA (Rapid Thermal Anneal) in a nitrogen atmosphere at 1,000° C for 1 minute, to thereby form the cathode 6, thus completing the silicon carbide semiconductor device 20 shown in Fig. 1, according to the first embodiment of the present invention.

In the method of producing the silicon carbide semiconductor device 20 according to the first embodiment, depositing the polycrystalline silicon layer 3 (made of the second semiconductor material) on the N silicon carbide substrate 100 (made of the first semiconductor material) can form the hetero junction HJ. In addition, the ion implantation is used for introducing the impurity (the phosphor 8) in the polycrystalline silicon layer 3, thereby accurately introducing the impurity (the phosphor 8).

Moreover, the polycrystalline silicon layer 3 having the first thickness 3T1 smaller than the range 8R of the phosphor 8 in the impurity introduction can, simultaneously with the impurity introduction in the polycrystalline silicon layer 3 by the ion implantation, introduce the impurity in the N⁻ silicon carbide epitaxial layer 2, to thereby form the impurity introducing area 4, resulting in the forming of the electric field relaxing area 5 in a self-matching manner.

### <First embodiment - operation>

Referring to an energy band structure from a point A to a point B in Fig. l, hereinafter described is a specific operation of the silicon carbide semiconductor device 20 thus produced according to the first embodiment.

Fig. 3A shows the energy band structure in a thermal equilibrium state where each of the N⁻ polycrystalline silicon layer 3A (the anode 7) and the cathode 6 is grounded.

A difference between an electron affinity χSiC of the silicon carbide and an electron affinity χPoly of the N⁻ polycrystalline silicon forms an accumulation layer on the N⁻ polycrystalline silicon layer 3A (the anode 7) side of the hetero junction HJ's interface under the thermal equilibrium state, to thereby form a barrierφh50 on the hetero junction HJ's interface.

With this, by grounding the cathode 6 and applying a proper voltage across the N⁻ polycrystalline silicon layer 3A (the anode 7) of the element allows an electron to flow from the cathode 6, via the N⁺ silicon carbide substrate 1, the N⁻ silicon carbide epitaxial layer 2 and the impurity introducing area 4, to the N⁻ polycrystalline silicon layer 3A (the anode 7), thus featuring a forward current of the diode.

Hereinafter described is a state where the N⁻ polycrystalline silicon layer 3A (the anode 7) of the element is grounded to thereby apply a high voltage to the cathode 6. In other words, hereinafter described is an operation where a reverse voltage is applied.

With the element, in the absence of the electric field relaxing area 5 including the impurity introducing area 4 and the hetero junction HJ, applying the reverse voltage applies a high electric field to the hetero junction HJ's interface, to thereby vary the energy band structure as shown in Fig. 3B, barring the electron 51 with the barrier φh50 caused by the hetero junction HJ's interface, thereby keeping the barring state.

In this case, with the thus applied high electric field, a part of the electron 51 accumulated on the N⁻ polycrystalline silicon layer 3A (the anode 7) side of the hetero junction HJ's interface tunnels in the barrier φh50, or goes over the barrier φh50, to thereby move from the N⁻ polycrystalline silicon layer 3A to the N⁻ silicon carbide epitaxial layer 2. Contrary to the above, in the presence of the electric field relaxing area 5, the electric field relaxing area 5 relaxes the electric field which covers the hetero junction HJ's interface, thereby decreasing a reverse leak current from the hetero junction HJ.

Fig. 4 shows the diode's reverse characteristic as a result of an experiment by the present inventor having prepared the silicon carbide semiconductor device 20, according to the first embodiment of the present invention. Compared with the diode without the electric field relaxing area 5, the diode with the electric field relaxing area 5 has a far lower reverse leak current, featuring a good reverse characteristic. As obvious from the experimental result in Fig. 4, the element has a high reverse blocking voltage even with the hetero junction HJ alone. Providing the electric field relaxing area 5, however, further decreases the leak current, realizing the diode featuring a further higher layer barring characteristic.

In addition, unlike a conventional edge termination area and the like, the silicon carbide semiconductor device 20 according to the first embodiment of the present invention can be formed without a high temperature active annealing, thereby preventing the N⁻ silicon carbide epitaxial layer 2's surface from being deteriorated. In addition, forming the electric field relaxing area 5 in the self-matching manner in the introducing of the impurity in the polycrystalline silicon layer 3 can make the process easier.

In addition, using the silicon carbide for the first semiconductor material can provide the semiconductor device 20 featuring a high reverse blocking voltage.

Moreover, using the polycrystalline silicon for the second semiconductor material (the polycrystalline silicon layer 3) can make the processes easier, including an etching or a conduction controlling in the production of the silicon carbide semiconductor device 20.

### <Second embodiment - structure>

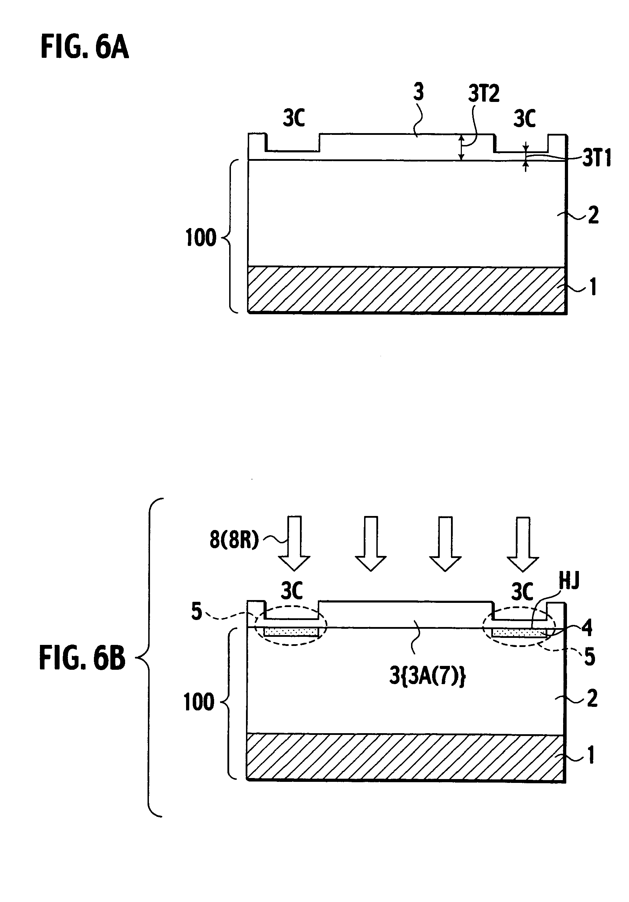

Fig. 5 and Fig. 6 (Fig. 6A and Fig. 6B) show the silicon carbide semiconductor device 20, according to a second embodiment of the present invention.
Fig. 5 is a cross sectional view showing a structure of the silicon carbide semiconductor device 20, according to the second embodiment of the present invention.

The silicon carbide semiconductor device 20 according to the second embodiment of the present invention is substantially the same in structure as the silicon carbide semiconductor device 20 according to the first embodiment, except the following difference: the electric field relaxing area 5 is formed only on an outer periphery 3C of the N⁻ polycrystalline silicon layer 3A (the anode 7), with the outer periphery 3C being so formed as to contact the N⁻ silicon carbide epitaxial layer 2.

### <Second embodiment - production method>

Hereinafter described is a method of producing the silicon carbide semiconductor device 20 in Fig. 5, according to the second embodiment of the present invention. Drawings like those of the method of producing the silicon carbide semiconductor device 20 according to the first embodiment of the present invention are to be omitted.

At first, the N silicon carbide semiconductor substrate 100 is prepared which has the N⁻ silicon carbide epitaxial layer 2 formed on the N⁺ silicon carbide substrate 1. The N⁻ silicon carbide epitaxial layer 2 has density and thickness, for example, 1 × 10¹⁶ cm⁻³ and 10 µm, respectively.

Then, as shown in Fig. 6A, a polycrystalline silicon is deposited on the N⁻ silicon carbide epitaxial layer 2 side of the N silicon carbide semiconductor substrate 100 by the LP-CVD method, to thereby form the polycrystalline silicon layer 3. In this case, the polycrystalline silicon layer 3 has a second thickness 3T2 larger than an ion range in the ion implantation in the introducing of the impurity. For example, under the ion implantation condition where the phosphor 8 is implanted with an acceleration voltage of 70 KeV and a dose quantity of 1 × 10¹⁴ cm⁻², the polycrystalline silicon layer 3 has the second thickness 3T2, for example, 5,000 angstrom.

Then, by the photolithography and etching, the outer periphery 3C of the polycrystalline silicon layer 3 has the first thickness 3T1 smaller than the ion range in the ion implantation in the impurity introduction. For example, under the above ion implantation condition, the first thickness 3T1 (of the polycrystalline silicon layer 3) smaller than the ion range is, for example, 1,000 angstrom, in a nutshell, forming an area where the polycrystalline silicon layer 3 has two different thicknesses including the first thickness 3T1 (smaller than the ion range of the ion implantation in the impurity introduction) and the second thickness 3T2 (larger than the ion range of the ion implantation in the impurity introduction).

Then, as shown in Fig. 6B, the phosphor 8 is introduced in the polycrystalline silicon layer 3 by the ion implantation method. As described above, the ion implantation condition includes, for example, the acceleration voltage of 70 KeV and the dose quantity of 1 × 10¹⁴ cm⁻². In this case, the phosphor 8 is implanted also in the N⁻ silicon carbide epitaxial layer 2 side directly below an area where the polycrystalline silicon layer 3 has the first thickness 3T1 smaller than the range 8R of the phosphor 8, to thereby form the impurity introducing area 4.

Thereby, the electric field relaxing area 5 is formed which includes: i) the hetero junction HJ between the N⁻ silicon carbide epitaxial layer 2 and the polycrystalline silicon layer 3 and ii) the impurity introducing area 4.

Then, the thus obtained is subjected to a heat treatment in a nitrogen atmosphere at 950° C for 20 minutes, to thereby activate (annealing) the phosphor 8 implanted in the polycrystalline silicon layer 3. Then, the polycrystalline silicon layer 3 is patterned by the photolithography and etching, to thereby form the N⁻ polycrystalline silicon layer 3A. In this case, the patterning is so implemented that the outer periphery 3C of the N⁻ polycrystalline silicon layer 3A is disposed on the impurity introducing area 4.

Then, Ti (titanium) and Ni (nickel) are sequentially deposited on the back face of the N⁺ silicon carbide substrate 1 by the spattering method. Then, the thus obtained is subjected to the RTA (Rapid Thermal Anneal) in the nitrogen atmosphere at 1,000 ° C for 1 minute, to thereby form the cathode 6, thus completing the silicon carbide semiconductor device 20 shown in Fig. 5.

The silicon carbide semiconductor device 20 thus produced according to the second embodiment has the electric field relaxing area 5 disposed on the outer periphery 3C the N⁻ polycrystalline silicon layer 3A (the anode 7) where the electric field is most concentrated when the reverse voltage is applied. Therefore, in addition to the effect brought about according to the first embodiment, the silicon carbide semiconductor device 20 according to the second embodiment has decreased leak current from the outer periphery 3C of the N⁻ polycrystalline silicon layer 3A (the anode 7), compared with the one without the electric field relaxing area 5, resulting in higher reverse blocking voltage.

Moreover, with the electric field relaxing area 5 disposed only on the outer periphery 3C of the N⁻ polycrystalline silicon layer 3A (the anode 7), the silicon carbide semiconductor device 20 according to the second embodiment has a forward current characteristic like the one without the electric field relaxing area 5 and has high reverse blocking voltage, realizing a low ON resistance.

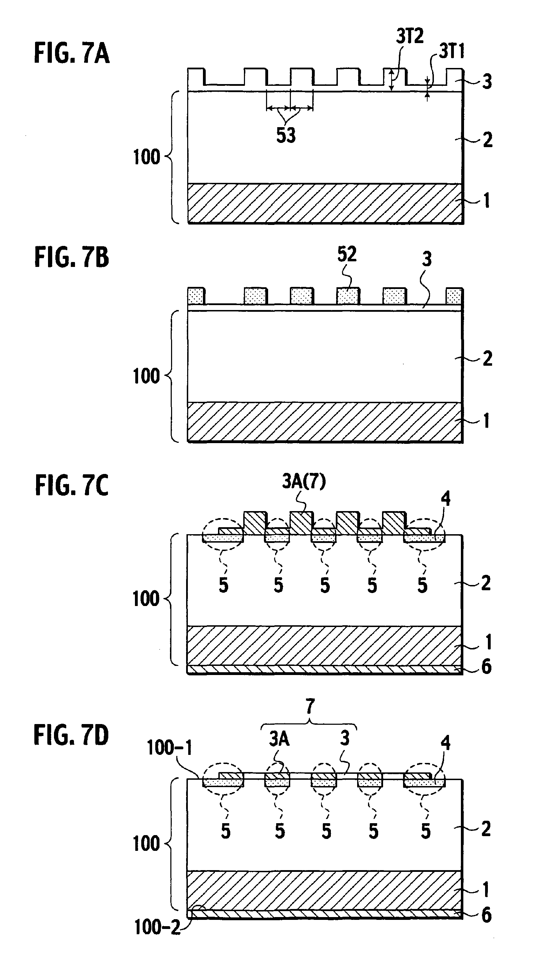

Herein, the silicon carbide semiconductor device 20 according to the second embodiment has the structure where the electric field relaxing area 5 is disposed on the outer periphery 3C of the N⁻ polycrystalline silicon layer 3A (the anode 7). Otherwise, taking any of the following patterning A and patterning B of the polycrystalline silicon layer 3 can selectively form the impurity introducing area 4 on the N⁻ silicon carbide epitaxial layer 2, in combination with the impurity introduction in the polycrystalline silicon layer 3:
Patterning A (Fig. 7A): So patterning that the polycrystalline silicon layer 3 has the first thickness 3T1 and the second thickness 3T2 which are respectively smaller and larger than the ion range of the ion implantation in the impurity introduction, where the first thickness 3T1 and the second thickness 3T2 are disposed alternately at a certain interval 53.
Patterning B (Fig. 7B): So forming the polycrystalline silicon layer 3 as to have the first thickness 3T1 smaller than the ion range of the ion implantation in the impurity introduction, followed by patterning a mask material 52 made of oxidized film.

With this, the electric field relaxing areas 5 are formed at the certain intervals 53 as shown in Fig. 7C and Fig. 7D, thus further improving the barring property in the reverse voltage application.

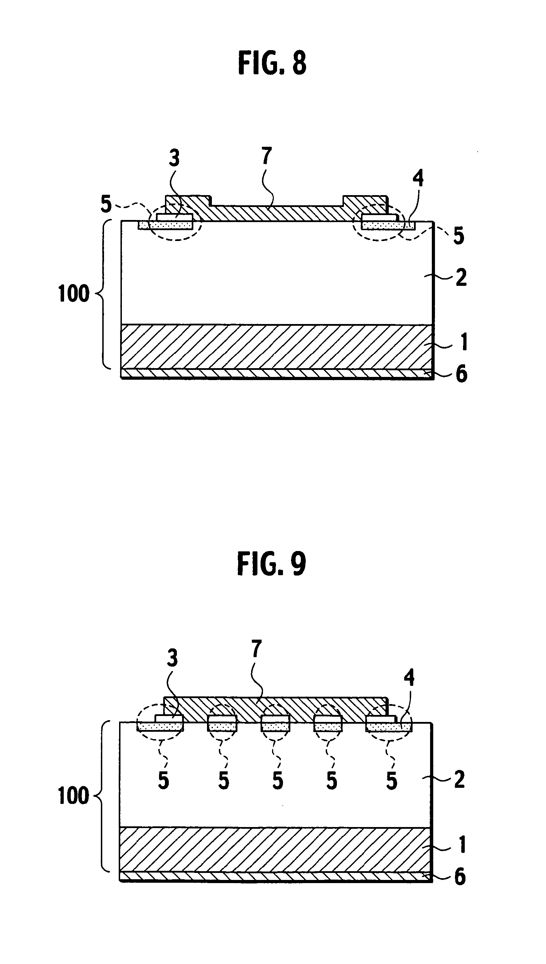

In addition, according to the first embodiment and the second embodiment, the N polycrystalline silicon layer 3A serves as the anode 7. Otherwise, the anode 7 made of metal as shown in Fig. 8 and Fig. 9 brings about the like effect.

According to the first embodiment and the second embodiment of the present invention, the diode is exemplified. Otherwise, the electric field relaxing area 5 under the present invention can be used as the simple edge termination as described above. Therefore, not limited to the diode, the electric field relaxing area 5 under the present invention is applicable to a switching element and the like.

### <Third embodiment - structure>

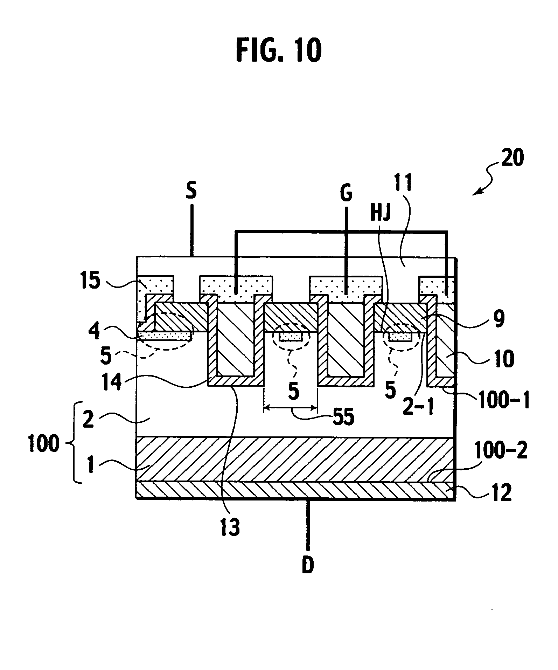

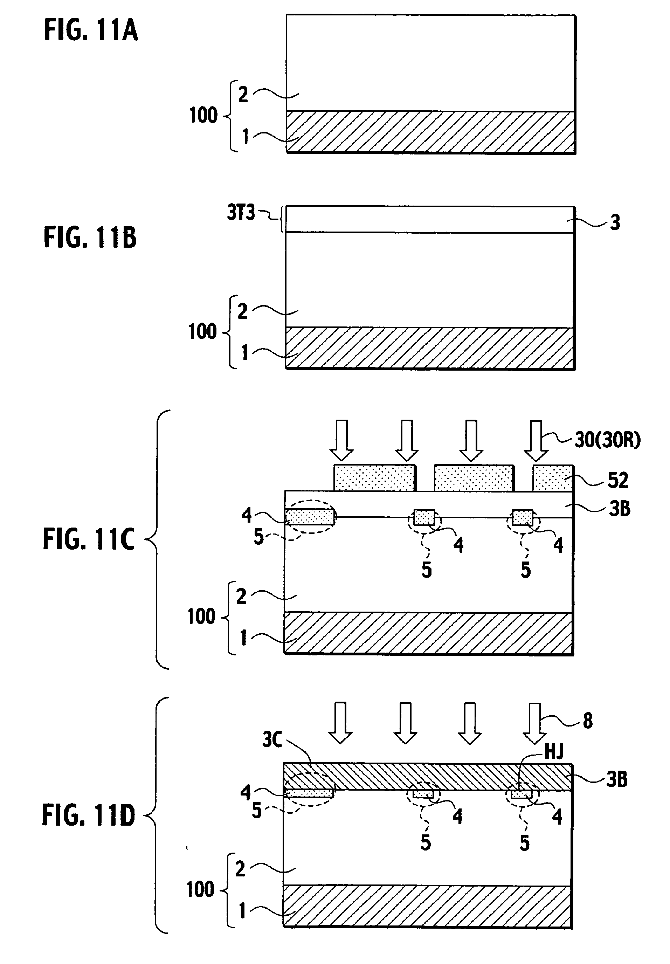

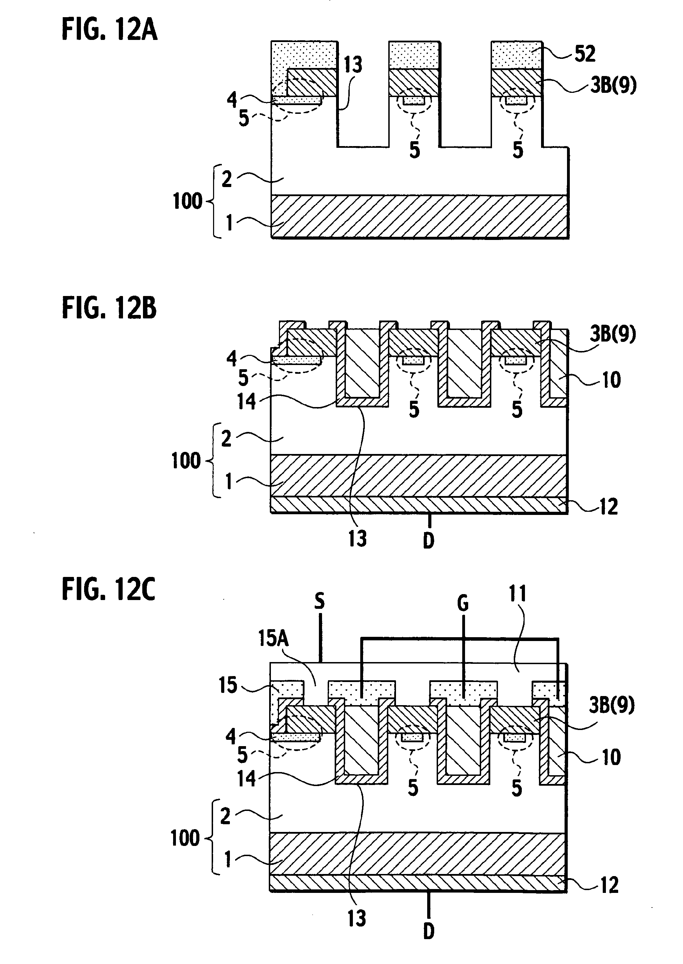

Fig. 10, Fig. 11 (Fig. 11A to Fig. 11D) and Fig. 12 (Fig. 12A to Fig. 12C) show the silicon carbide semiconductor device 20, according to a third embodiment of the present invention. Fig. 10 is a cross sectional view showing a structure of the silicon carbide semiconductor device 20, according to the third embodiment of the present invention. The silicon carbide semiconductor device 20 according to the third embodiment in Fig. 10 shows a cross sectional structure of outer peripheries of a multiple of arranged unit cells, specifically, three continuous unit cells. In Fig. 10 and Fig. 12C, S denotes source, G denotes gate and D denotes drain.

In Fig. 10, forming the N' silicon carbide epitaxial layer 2 on the N⁺ silicon carbide substrate 1 forms the N silicon carbide semiconductor substrate 100 which is the first conductive type. In other words, the N silicon carbide semiconductor substrate 100 made of the first semiconductor material which is the silicon carbide includes the N⁺ silicon carbide substrate 1 and the N⁻ silicon carbide epitaxial layer 2.

On the first main face 100-1 side of the N silicon carbide semiconductor substrate 100, in other words, on the N⁻ silicon carbide epitaxial layer 2 side, there are formed trenches 13 (grooves) at certain intervals 55. In a certain position on a first main face 2-1 side of the N⁻ silicon carbide epitaxial layer 2, there is formed a source area 9 made of N⁻ polycrystalline silicon which is a semiconductor material different from the N silicon carbide semiconductor substrate 100 in band gap, thus forming the hetero junction HJ between the N⁻ silicon carbide epitaxial layer 2 and the source area 9.

Adjacent to the N⁻ silicon carbide epitaxial layer 2 (on a side wall of the trench 13) and the source area 9, a gate electrode 10 is formed via a gate insulating film 14. A source electrode 11 is formed on the source area 9, and a drain electrode 12 is formed on a second main face 100-2 side of the N⁺ silicon carbide substrate 1. On the outer peripheries of the multiple unit cells and on the N⁻ silicon carbide epitaxial layer 2 side in a certain area between the trenches 13, there is formed the electric field relaxing area 5 including the impurity introducing area 4 so formed as to contact the hetero junction HJ. The gate electrode 10 and the source electrode 11 are electrically insulated by a layer-to-layer insulating film 15.

### <Third embodiment - production method>

Hereinafter described referring to Fig. 11 and Fig. 12 is a method of producing the silicon carbide semiconductor device 20 in Fig. 10, according to the third embodiment of the present invention.

At first, as shown in Fig. 11A, the N silicon carbide semiconductor substrate 100 is prepared which has the N⁻ silicon carbide epitaxial layer 2 formed on the N⁺ silicon carbide substrate 1. The N⁻ silicon carbide epitaxial layer 2 has density and thickness, for example 1 × 10¹⁶ cm⁻³ and 10 µm, respectively.

Then, as shown in Fig. 11B, a polycrystalline silicon is deposited on the N⁻ silicon carbide epitaxial layer 2 side of the N silicon carbide semiconductor substrate 100 by the LP-CVD method, to thereby form the polycrystalline silicon layer 3. In this case, the polycrystalline silicon layer 3 has a third thickness 3T3, for example, 5,000 angstrom.

Then, as shown in Fig. 11C, the mask material 52 is used for an ion implantation of a boron 30 to a certain area of the N⁻ silicon carbide epitaxial layer 2 via the polycrystalline silicon layer 3. In this case, an acceleration voltage of the boron 30 is so set that an implantation range 30R of the boron 30 is larger than the third thickness 3T3 of the polycrystalline silicon layer 3. According to the third embodiment, for example, the acceleration voltage is 200 keV and the dose quantity is 5 × 10¹³ cm⁻².

Implementing the ion implantation under the above conditions can implant the boron 30 in a part of the polycrystalline silicon layer 3 and on the N⁻ silicon carbide epitaxial layer 2 side directly below the polycrystalline silicon layer 3, to thereby form the impurity introducing area 4.

Then, as shown in Fig. 11D, the phosphor 8 is subjected to an ion implantation in an entire face of the polycrystalline silicon layer 3, followed by the heat treatment in the nitrogen atmosphere at 950 °C for 20 minutes, to thereby form an N⁺ polycrystalline silicon layer 3B. The conditions for implanting the phosphor 8 according to the third embodiment include, for example, an acceleration voltage of 50 keV and a dose quantity of 1 × 10¹⁶ cm⁻².

In the above operation in Fig. 11C, the boron 30 is implanted in a part of the polycrystalline silicon layer 3, while the phosphor 8 implanted by the operation in Fig. 11D is higher than the implanted boron 30 in density by more than or equal to two-digit. As a result, the entirety of the polycrystalline silicon layer 3 features N⁺ {thus, N⁺ polycrystalline silicon layer 3B} after the heat treatment in the nitrogen atmosphere at 950° C for 20 minutes. The operations in Fig. 11C and Fig. 11D form the electric field relaxing area 5 including: i) the hetero junction HJ between the N⁻ silicon carbide epitaxial layer 2 and the N⁺ polycrystalline silicon layer 3B and ii) the impurity introducing area 4. Then, the outer periphery 3C of the N⁺ polycrystalline silicon layer 3B is etched by the photolithography and etching.

Then, as shown in Fig. 12A, the mask material 52 is used for etching certain areas of the N⁺ polycrystalline silicon layer 3B and the silicon carbide epitaxial layer 2 by a reactive ion etching, to thereby form the source area 9 and the trench 13. Then, the mask material 52 is removed.

Then, as shown in Fig. 12B, adjacent to the N⁻ silicon carbide epitaxial layer 2 (on the side wall of the trench 13) and the source area 9 , the gate insulating film 14 is formed, to thereafter form, via the gate insulating film 14, the gate electrode 10 in the trench 13.

Then, the layer-to-layer insulating film 15 is deposited, as shown in Fig. 12C, followed by an opening of a contact hole 15A, to thereby form the source electrode 11 contacting the source area 9. Meanwhile, the drain electrode 12 is formed on the back face of the N⁺ silicon carbide substrate 1, to thereby complete the silicon carbide semiconductor device 20 in Fig. 10.

### <Third embodiment - operation>

Hereinafter described is a specific operation of the thus produced silicon carbide semiconductor device 20, according to the third embodiment. The element is used in such a manner that the source electrode 11 is grounded and a positive drain voltage is applied to the drain electrode 12.

In this case, with the gate electrode 10 grounded, the element according to the third embodiment has a characteristic like the reverse characteristic of the silicon carbide semiconductor device 20 in Fig. 3B according to the first embodiment. In other words, the current does not flow between the source electrode 11 and the drain electrode 12, causing the barring state.

Then, applying a proper positive voltage to the gate electrode 10 accumulates the electron 51 i) in the source area 9 which is disposed adjacent to the gate insulating film 14 and is made of polycrystalline silicon, and ii) in the N⁻ silicon carbide epitaxial layer 2, resulting in flow of current between the source electrode 11 and the drain electrode 12 with a certain drain voltage D, thus bringing about a conductive state.

Moreover, removing the positive voltage applied to the gate electrode 10 eliminates the accumulation layer of the electron 51 from the source area 9 and the N⁻ silicon carbide epitaxial layer 2 which are disposed adjacent to the gate insulating film 14. With this, the barrier φh50 (refer to Fig. 3A) on the hetero junction HJ's interface bars the electron 51, thus bringing about the barring state.

On the outer peripheries of the multiple of the unit cells and on the N⁻ silicon carbide epitaxial layer 2 side in the certain area between the trenches 13 (in which two places the electric field is likely to be concentrated in the applying of the drain voltage), the element has the electric field relaxing area 5 including the impurity introducing area 4 so formed as to contact the hetero junction HJ. The electric field relaxing area 5, can relax the electric field on the outer periphery in the applying of the drain voltage, thus bringing about a high drain reverse blocking voltage.

In addition, in the reverse conduction of the element, the electric field relaxing area 5 serves as a unipolar reflux diode, thus eliminating the need of providing a reflux diode in the switching element, thereby decreasing an area per unit cell. In other words, the ON resistance can be further decreased. In addition, the electric field relaxing area 5 serving as the reflux diode is the unipolar element, thus preventing implantation of minority carriers. Thereby, power loss in the switching operation can be decreased.

According to the third embodiment, the impurity introduced in the impurity introducing area 4 is the boron 30, while the impurity introduced in polycrystalline silicon layer 3 made of the second semiconductor material is the phosphor 8, as shown in Fig. 11C and Fig. 11D. The impurities and the combinations thereof are, however, not limited to the above. For example, the impurities introduced in the impurity introducing area 4 may be, other than the boron 30, argon, phosphor, arsenic, aluminum, vanadium, sulfur and the like. In addition, the impurities introduced in the polycrystalline silicon layer 3 may be, other than the phosphor 8, arsenic, antimony, boron, aluminum, gallium and the like.

### <Fourth embodiment - structure>

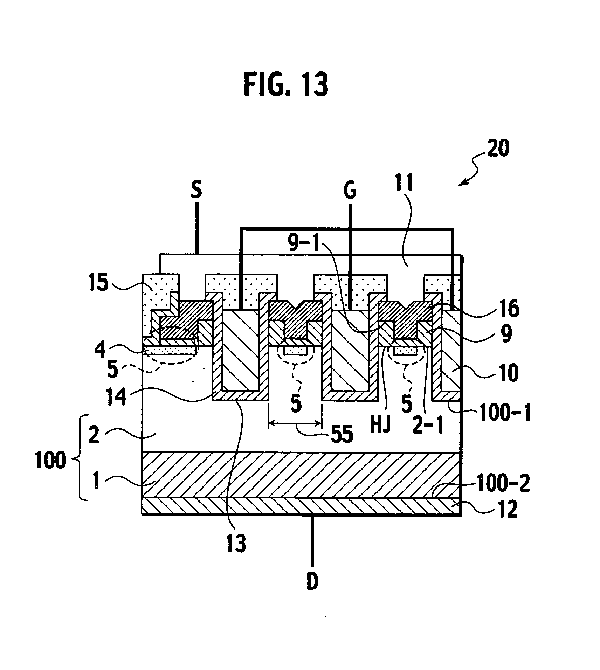

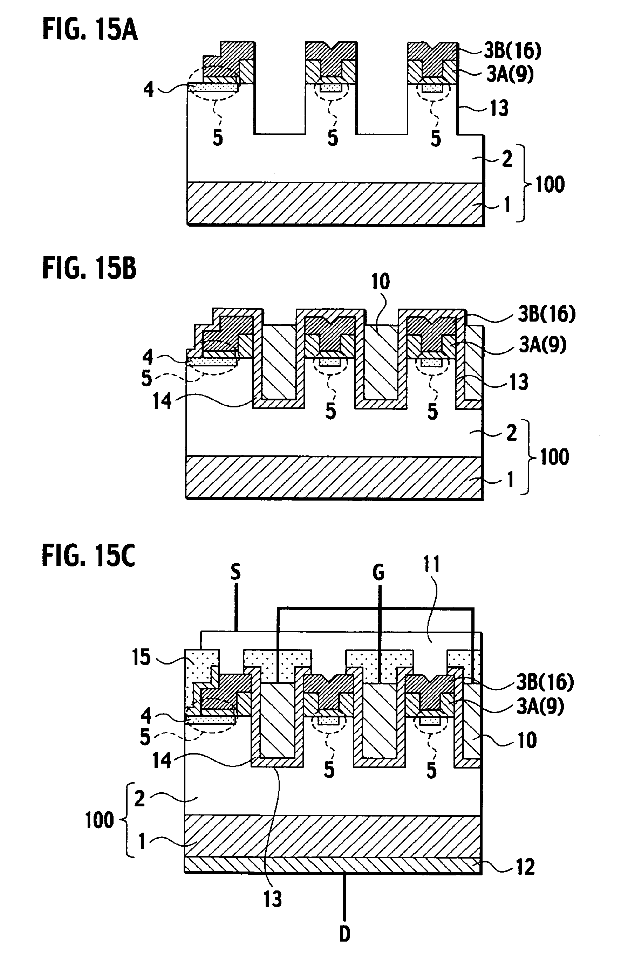

Fig. 13 to Fig. 15 show the silicon carbide semiconductor device 20, according to a fourth embodiment of the present invention. Fig. 13 is a cross sectional view showing a structure of the silicon carbide semiconductor device 20, according to the fourth embodiment of the present invention. As shown in Fig. 13, the silicon carbide semiconductor device 20 has a cross sectional structure of outer peripheries of a multiple of arranged unit cells, specifically, three continuous unit cells. In Fig. 13 and Fig. 15C, S denotes source, G denotes gate and D denotes drain.

In Fig. 13, forming the N⁻ silicon carbide epitaxial layer 2 on the N⁺ silicon carbide substrate 1 forms the N silicon carbide semiconductor substrate 100 which is the first conductive type. In other words, the N silicon carbide semiconductor substrate 100 made of the first semiconductor material which is the silicon carbide includes the N⁺ silicon carbide substrate 1 and the N⁻ silicon carbide epitaxial layer 2. On the first main face 100-1 side of the N silicon carbide semiconductor substrate 100, in other words, on the N⁻ silicon carbide epitaxial layer 2 side, there are formed the trenches 13 (grooves) at the certain intervals 55.

In a certain position on the first main face 2-1 side of the N⁻ silicon carbide epitaxial layer 2, there is formed the source area 9 made of the N⁻ polycrystalline silicon which is the semiconductor material different from the N silicon carbide semiconductor substrate 100 in band gap, thus forming the hetero junction HJ between the N⁻ silicon carbide epitaxial layer 2 and the source area 9. In a certain position on a first main face 9-1 side of the source area 9, a source contact area 16 made of N⁺ polycrystalline silicon is so formed as to contact the source area 9.

Adjacent to the N⁻ silicon carbide epitaxial layer 2 (on the side wall of the trench 13), the source area 9 and the source contact area 16, the gate electrode 10 is formed via the gate insulating film 14. The source electrode 11 is formed on the source contact area 16, and the drain electrode 12 is formed on the second main face 100-2 side of the N⁺ silicon carbide substrate 1.

On the outer peripheries of the multiple of the unit cells and on the N⁻ silicon carbide epitaxial layer 2 side in a certain area between the trenches 13, there is formed the electric field relaxing area 5 including the impurity introducing area 4 so formed as to contact the hetero junction HJ. The gate electrode 10 and the source electrode 11 are electrically insulated by the layer-to-layer insulating film 15.

### <Fourth embodiment - production method>

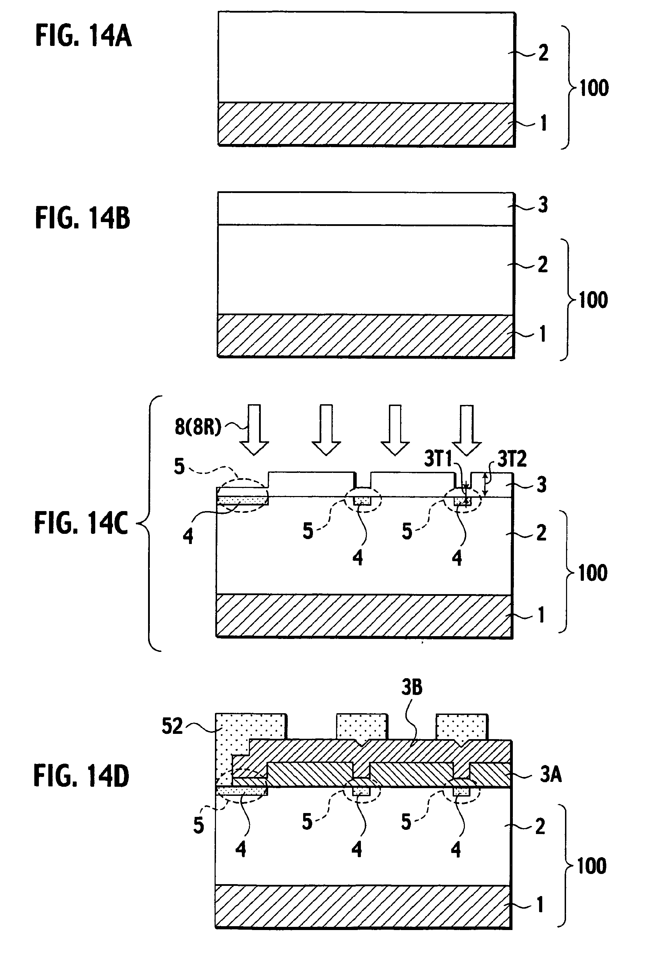

Hereinafter described referring to Fig. 14 and Fig. 15 is a method of producing the silicon carbide semiconductor device 20 in Fig. 13, according to the fourth embodiment of the present invention.

At first, as shown in Fig. 14A, the N silicon carbide semiconductor substrate 100 is prepared which has the N⁻ silicon carbide epitaxial layer 2 formed on the N⁺ silicon carbide substrate 1. The N⁻ silicon carbide epitaxial layer 2 has density and thickness, for example 1 × 10¹⁶ cm⁻³ and 10 µm, respectively.

Then, as shown in Fig. 14B, a polycrystalline silicon is deposited on the N⁻ silicon carbide epitaxial layer 2 side of the N silicon carbide semiconductor substrate 100 by the LP-CVD method, to thereby form the polycrystalline silicon layer 3. In this case, the polycrystalline silicon layer 3 has the second thickness 3T2 larger than the ion range of ion implantation in the impurity introduction in the introducing of the impurity. For example, under the ion implantation condition where the phosphor 8 is implanted with an acceleration voltage of 70 KeV and a dose quantity of 1 × 10¹⁴ cm⁻², the polycrystalline silicon layer 3 has the second thickness 3T2, for example, 5,000 angstrom.

Then, as shown in Fig. 14C, by the photolithography and etching, the polycrystalline silicon layer 3 is caused to have two different thicknesses including the first thickness 3T1 (smaller than the ion range of the ion implantation in the impurity introduction) and the second thickness 3T2 (larger than the ion range of the ion implantation in the impurity introduction). Then, the phosphor 8 is introduced in the polycrystalline silicon layer 3 by the ion implantation method.
As described above, the ion implantation condition includes, for example, an acceleration voltage of 70 KeV and a dose quantity of 1 × 10¹⁴ cm⁻².

In this case, the phosphor 8 is implanted also in the N⁻ silicon carbide epitaxial layer 2 side directly below an area where the polycrystalline silicon layer 3 has the first thickness 3T1 smaller than the range 8R of the phosphor 8, to thereby form the impurity introducing area 4. Thereby, the electric field relaxing area 5 is formed which includes: i) the hetero junction HJ between the N⁻ silicon carbide epitaxial layer 2 and the polycrystalline silicon layer 3 and ii) the impurity introducing area 4. Then, the thus obtained is subjected to a heat treatment in a nitrogen atmosphere at 950° C for 20 minutes, to thereby activate (annealing) the phosphor 8 implanted in the polycrystalline silicon layer 3, thus forming the N⁻ polycrystalline silicon layer 3A.

Then, as shown in Fig. 14D, the N⁺ polycrystalline silicon layer 3B is formed on an upper face of the N⁻ polycrystalline silicon layer 3A, to thereby pattern the N⁻ polycrystalline silicon layer 3A and the N⁺ polycrystalline silicon layer 3B by the photolithography and etching. After the patterning, the oxidized film is deposited, followed by patterning of the oxidized film by the photolithography and etching, to thereby form the mask material 52.

Then, as shown in Fig. 15A, with the thus formed mask material 52, the N⁻ polycrystalline silicon layer 3A, the N⁺ polycrystalline silicon layer 3B and the N⁻ silicon carbide epitaxial layer 2 are etched by the reactive ion etching, to thereby form the source area 9, the source contact area 16 and the trench 13. Then, the mask material 52 is removed.

In addition, as shown in Fig. 15B, adjacent to the N⁻ silicon carbide epitaxial layer 2 (on the side wall of the trench 13), the source area 9 and the source contact area 16, the gate insulating film 14 is formed, to thereby form the gate electrode 10 in the trench 13 via the gate insulating film 14.

Then, as shown in Fig. 15C, the layer-to-layer insulating film 15 is deposited, followed by the opening of the contact hole 15A, to thereby form the source electrode 9 contacting the source contact area 16 made of N⁺ polycrystalline silicon. Then, the drain electrode 12 is formed on the back face of the N⁺ silicon carbide substrate 1, to thereby complete the silicon carbide semiconductor device 20 in Fig. 13.

### <Fourth embodiment - operation>

The thus produced the silicon carbide semiconductor device 20 according to the fourth embodiment shows a like operation to that of the silicon carbide semiconductor device 20 according to the third embodiment.

Although the present invention has been described above by reference to four embodiments, the present invention is not limited to the four embodiments described above. Modifications and variations of any of the four embodiments described above will occur to those skilled in the art, in light of the above teachings.

The source area 9 according to the fourth embodiment has the accumulated MOSFET including the N⁻ polycrystalline silicon. The source area 9 may, however, have a reversed MOSFET including the N⁻ polycrystalline silicon, in this case, the boron 30 and the like can be used for the ion implantation to the source area 9.

As described above, the longitudinal MOSFET has been exemplified as the switching element, according to the third embodiment and the fourth embodiment. Another switching element having an active area including a source area, a drain area G and a drive area may replace the longitudinal MOSFET.

For example, a lateral switching element including: i) a unipolar device such as MOSFET, JFET and the like, ii) a bipolar device such as IGBT, and iii) an MOSFET having RESURF structure can bring about a like effect.

In addition, the first, second, third and fourth embodiments of the present invention each describe the N type first conduction and the P type second conduction. Alternatively, a P type first conduction and an N type second conduction can also bring about the like effect.

Moreover, the first, second, third and fourth embodiments of the present invention each describe the first semiconductor material as the silicon carbide and the second semiconductor material as the polycrystalline silicon. The present invention, is however, not limited to the above semiconductor materials.

For example, any other semiconductor materials such as a wide gap semiconductor including gallium nitride, diamond, oxidized zinc and the like, or germanium, gallium arsenide, indium nitride and the like can bring about the like effect.

In other words, the second semiconductor material may be any of a single crystal silicon, a polycrystalline silicon, and an amorphous silicon.

This application is based on a prior Japanese Patent Application No. P2005-021465 (filed on January 28, 2005 in Japan). The entire contents of the Japanese Patent Application No. P2005-021465 are incorporated herein by reference, in order to take some protection against translation errors or omitted portions.

The scope of the present invention is defined with reference to the following claims.

## Claims

1. A semiconductor device (20), comprising:
1) an electric field relaxing area (5), including:
i) a hetero junction (HJ) formed by the followings:
a) a first semiconductor material (100: 1, 2), and
b) a second semiconductor material {3A (7)} different from the first semiconductor material (100: 1, 2) in band gap, and
ii) an impurity introducing area (4) so formed on the first semiconductor material (100: 1, 2) as to contact the hetero junction (HJ).

2. A semiconductor device (20), comprising:
1) a semiconductor substrate (100: 1, 2) made of a first semiconductor material (100) which is a first conductive type;
2) an anode {3A (7)} so formed as to contact a first main face (100-1) of the semiconductor substrate (100: 1,2);
3) a cathode (6) so formed as to contact a second main face (100-2) of the semiconductor substrate (100: 1, 2), the second main face (100-2) opposing the first main face (100-1); and
4) an electric field relaxing area (5), including:
i) a hetero junction (HJ) disposed between the anode {3A (7)} and the semiconductor substrate (100: 1, 2), the hetero junction (HJ) formed by the followings:
a) the first semiconductor material (100: 1, 2), and
b) a second semiconductor material {3A (7)} different from the first semiconductor material (100: 1, 2) in band gap, and
ii) an impurity introducing area (4) so formed on the first semiconductor material (100: 1, 2) as to contact the hetero junction (HJ).

3. The semiconductor device (20) as claimed in claim 2, wherein
the electric field relaxing area (5) is disposed on an outer periphery (3C) of the anode {3A (7)}.

4. The semiconductor device (20) as claimed in any one of claim 2 and claim 3, wherein
the electric field relaxing areas (5) are disposed at a certain interval (53).

5. A semiconductor device (20), comprising:
1) a switching element including an active area which includes at least the followings each of which is formed in a certain position of a semiconductor substrate (100: 1, 2) made of a first semiconductor material (100: 1, 2),
i) a source area (S),
ii) a drain area (D), and
iii) a drive area; and
2) an electric field relaxing area (5), including:
i) a hetero junction (HJ) formed by the followings:
a) the first semiconductor material (100: 1,2), and
b) a second semiconductor material (9) different from the first semiconductor material (100: 1, 2) in band gap, and
ii) an impurity introducing area (4) so formed on the first semiconductor material (100: 1, 2) as to contact the hetero junction (HJ).

6. The semiconductor device (20) as claimed in claim 5, wherein
the electric field relaxing area (5) is disposed on an outer periphery of the active area.

7. The semiconductor device (20) as claimed in any one of claim 5 and claim 6, wherein
the electric field relaxing area (5) is disposed at least one part in the active area.

8. The semiconductor device (20) as claimed in any one of claim 5 to claim 7, wherein
the switching element includes:
1) the drain area (D) made of the semiconductor substrate (100: 1, 2),
2) the source area (9) made of the second semiconductor material (9) different from the first semiconductor material (100: 1, 2) in the band gap,
3) a gate electrode (10) adjacent to the semiconductor substrate (100: 1, 2) and the source area (9) via a gate insulating film (14),
4) a source electrode (11) so formed as to contact the source area (9), and
5) a drain electrode (12) so formed as to contact the drain area (D).

9. The semiconductor device (20) as claimed in claim 8, wherein
a groove (13) is formed in a certain position of a first main face (100-1) of the semiconductor substrate (100: 1, 2).

10. The semiconductor device (20) as claimed in any one of claim 1 to claim 9, wherein
the first semiconductor material (100: 1, 2) is a silicon carbide.

11. The semiconductor device (20) as claimed in any one of claim 1 to claim 10, wherein
the second semiconductor material (3, 9) is at least one of a single crystal silicon, a polycrystalline silicon, and an amorphous silicon.

12. A method of producing the semiconductor device (20) as claimed in any one of claim 1 to claim 11, the method comprising:
1) forming the hetero junction (HJ) by the followings:
i) the first semiconductor material (100: 1, 2), and
ii) the second semiconductor material (3) different from the first semiconductor material (100: 1, 2) in band gap;
2) introducing an impurity (8, 30) to the second semiconductor material (3); and
3) forming the impurity introducing area (4).

13. The method of producing the semiconductor device (20), as claimed in claim 12, wherein
the forming of the impurity introducing area (4) is implemented by introducing the impurity (8, 30) in the first semiconductor material (100: 1, 2) via the second semiconductor material (3).

14. The method of producing the semiconductor device (20), as claimed in any one of claim 12 and claim 13, wherein
the forming of the impurity introducing area (4) implemented substantially simultaneously with the introducing of the impurity (8) in the second semiconductor material (3).

15. The method of producing the semiconductor device (20), as claimed in any one of claim 12 to claim 14, wherein
the introducing of the impurity (8, 30) is implemented by an ion implantation.

16. The method of producing the semiconductor device (20), as claimed in any one of claim 12 to claim 15, wherein
the second semiconductor material (3) is so formed that any one of an entirety and a part of the second semiconductor material (3) has a first thickness (3T1) smaller than a range (8R) of the impurity (8) introduced by the ion implantation.

17. The method of producing semiconductor device (20), as claimed in any one of claim 12 to claim 16, wherein
the first semiconductor material (100: 1, 2) is a silicon carbide.

18. The method of producing semiconductor device (20), as claimed in any one of claim 12 to claim 17, wherein
the second semiconductor material (3, 9) is at least one of a single crystal silicon, a polycrystalline silicon, and an amorphous silicon.

## Amended claims

### Amended claims in accordance with Rule 137(2) EPC.

**1.** A semiconductor device (20), comprising:
1) an electric field relaxing area (5), including:
i) a hetero junction (HJ) formed by the followings:
a) a first semiconductor material (100: 1, 2), and
b) a second semiconductor material {3A (7)} different from the first semiconductor material (100: 1, 2) in band gap, and
ii) an impurity introducing area (4) provided on the first semiconductor material (100: 1, 2) to contact the hetero junction (HJ)
**characterized in**
**that** an entirety or a part of the second semiconductor material {3A (7)} has a thickness (3T1, 3T3) smaller than a range (8R, 30R) of an impurity (8, 30) introduced to the impurity introducing area (4) via the thickness (3T1, 3T3) by an ion implantation.

**2.** The semiconductor device (20) according to claim 1, **characterized in that** it further comprises
1) a semiconductor substrate (100: 1, 2) made of a first semiconductor material (100) which is a first conductive type;
2) an anode {3A (7)} provided to contact a first main face (100-1) of the semiconductor substrate (100: 1, 2); and
3) a cathode (6) provided to contact a second main face (100-2) of the semiconductor substrate (100: 1, 2), wherein the second main face (100-2) opposes the first main face (100-1).

**3.** The semiconductor device (20) according to claim 2, **characterized in**
**that** the electric field relaxing area (5) is disposed on an outer periphery (3C) of the anode {3A (7)}.

**4.** The semiconductor device (20) according to claims 2 or 3, **characterized in**
**that** it comprises at least a further electric field relaxing area (5) disposed at a certain interval (53) from the electric field relaxing area (5).

**5.** The semiconductor device (20) according to claim 1, **characterized in**
**that** it further comprises
1) a switching element including an active area which includes at least the followings each of which is formed in a certain position of a semiconductor substrate (100: 1, 2) made of a first semiconductor material (100: 1, 2),
i) a source area (S),
ii) a drain area (D), and
iii) a drive area.

**6.** The semiconductor device (20) according to claim 5, **characterized in**
**that** the electric field relaxing area (5) is disposed on an outer periphery of the active area.

**7.** The semiconductor device (20) according to claims 5 or 6, **characterized in**
**that** the electric field relaxing area (5) is disposed at least one part in the active area.

**8.** The semiconductor device (20) according to any one of claims 5 to 7, **characterized in**
**that** the switching element includes:
1) the drain area (D) made of the semiconductor substrate (100: 1, 2),
2) the source area (9) made of the second semiconductor material (9) different from the first semiconductor material (100: 1, 2) in the band gap,
3) a gate electrode (10) adjacent to the semiconductor substrate (100: 1, 2) and the source area (9) via a gate insulating film (14),
4) a source electrode (11) provided to contact the source area (9), and
5) a drain electrode (12) provided to contact the drain area (D).

**9.** The semiconductor device (20) according to claim 8, **characterized in**
**that** a groove (13) is formed in a certain position of a first main face (100-1) of the semiconductor substrate (100: 1, 2).

**10.** The semiconductor device (20) according to any one of claims 1 to 9, **characterized in**
**that** the first semiconductor material (100: 1, 2) is a silicon carbide.

**11.** The semiconductor device (20) according to any one of claims 1 to 10, **characterized in**
**that** the second semiconductor material (3, 9) is at least one of a single crystal silicon, a polycrystalline silicon, and an amorphous silicon.

**12.** A method of producing the semiconductor device (20) according to any one of claims 1 to 11, **characterized in that** the method comprises the steps of:
1) forming the hetero junction (HJ) by the followings:
i) the first semiconductor material (100: 1, 2), and
ii) the second semiconductor material (3) different from the first semiconductor material (100: 1, 2) in band gap;
2) introducing an impurity (8, 30) to the second semiconductor material (3) by ion implantation, wherein the second semiconductor material (3) is so formed that any one of an entirety and a part of the second semiconductor material (3) has a thickness (3T1, 3T3) smaller than a range (8R, 30R) of the impurity (8, 30) introduced by the ion implantation; and
3) forming the impurity introducing area (4) by introducing the impurity (8, 30) in the first semiconductor material (100: 1, 2) via the second semiconductor material (3).

**13.** The method of producing the semiconductor device (20), according to claim 12 , **characterized in**
**that** the forming of the impurity introducing area (4) is implemented substantially simultaneously with the introducing of the impurity (8) in the second semiconductor material (3).

**14.** The method of producing semiconductor device (20), according to claims 12 or 13, **characterized in**
**that** the first semiconductor material (100: 1, 2) is a silicon carbide.

**15.** The method of producing semiconductor device (20), according to any one of claims 12 to 14, **characterized in**
**that** the second semiconductor material (3, 9) is at least one of a single crystal silicon, a polycrystalline silicon, and an amorphous silicon.
